# EUROPEAN PATENT SPECIFICATION

(11) **EP 0 874 540 B1**
(45) Date of publication and mention of the grant of the patent: **23.06.2004**
(21) Application number: 96923070.5
(22) Date of filing: 12.07.1996
(51) Int. Cl.: H05K 13/02, H05K 13/04

(54) **METHOD AND APPARATUS FOR MOUNTING ELECTRONIC COMPONENTS**
VERFAHREN UND VORRICHTUNG ZUR BESTÜCKUNG ELEKTRONISCHER BAUTEILE
PROCEDE ET DISPOSITIF DE MONTAGE DE COMPOSANTS ELECTRONIQUES

(30) Priority: 12.07.1995 JP 17579695
(43) Date of publication of application: 28.10.1998
(73) Proprietor: MATSUSHITA ELECTRIC INDUSTRIAL CO., LTD., Kadoma-shi, Osaka 571-8501 (JP)
(72) Inventor: SAKURAI, Kunio, Osaka 591 (JP); HIRAI, Wataru, Osaka 543 (JP); YAMAMOTO, Minoru, Osaka 536 (JP); MOGI, Seiichi, Osaka 572 (JP)
(74) Representative: Eisenführ, Speiser & Partner
(86) International application number: PCT/JP1996/001942
(87) International publication number: WO 1997/003546

(56) References cited:
- JP-A- 3 217 086
- JP-A- 61 188 363
- US-A- 4 768 915

## Description

### TECHNICAL FIELD

The present invention relates to electronic component mounting method and apparatus by which an electronic component is automatically mounted to a specified position on an electronic circuit board.

### BACKGROUND ART

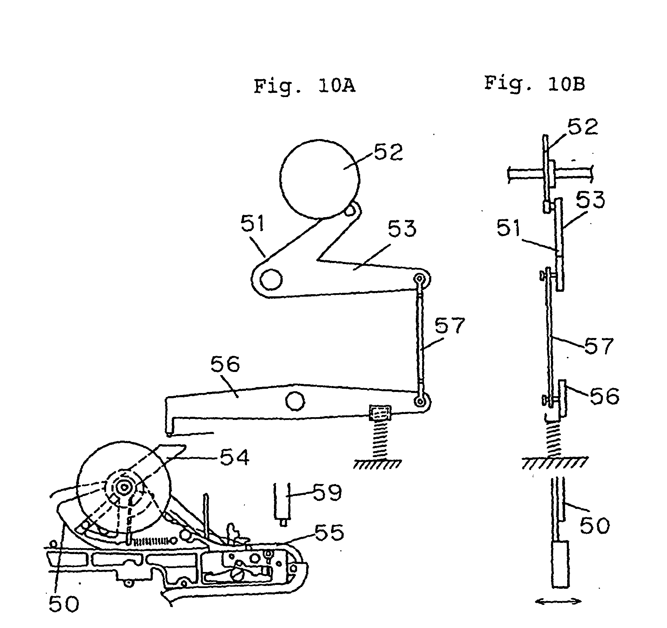

A conventional electronic component mounting apparatus, as shown in Figs. 10A. 10B, comprises a component feed unit 50 for feeding out a plurality of components accommodated therein one after another, and a cam lever mechanism 51 for driving the component feed unit 50 at a specified component feed position.

The component feed unit 50, which is loaded with a carrier tape having a multiplicity of components accommodated thereon, feeds forward the tape by a pitch corresponding to a push amount each time a feed lever 54 is pushed, by which the component feed unit 50 feeds out the components one by one to a specified feed-out position 55, where the components are vacuum-picked up (sucked) by a component pickup head 59 that serves for component mounting.

The cam lever mechanism 51 transfers a motion of a bell crank 53 driven by a cam 52, to a feed driving lever 56 via a rod 57. Then, the resulting swing of the feed driving lever 56 causes a roller 58 provided at its end to contact a feed lever 54 and thereby push it to a certain amount, by which the component feed is accomplished.

In this case, using the cam lever mechanism makes it possible to drive a sequence of operations, such as the feeding of a component, and the rotation and up-and-down driving of the pickup nozzle, in synchronization mechanically. This in turn makes it possible to provide a reliable electronic component mounting apparatus.

In the above prior art example, one cam lever mechanism 51 is uniformly used to drive the component feed unit 50. However, because the amount to which an electronic component is intermittently fed varies from large to small depending on the size type of the electronic component, there has been an issue that a smaller amount of intermittent feed causes loss of the swinging stroke of the roller 58, making it impossible to obtain higher speed. That is, although small-size electronic components would allow the mounting apparatus to be operated at higher speed so that higher-speed mounting could be achieved and moreover small-size electronic components would involve smaller amounts of intermittent feed so that higher-speed mounting can be achieved by lessening the driving amount for the feed lever 54, it has conventionally been the case that there has been a limitation in enhancing the speed of operation because the component feed unit 50 is driven uniformly regardless of the type of electronic components, so that high-speed mounting cannot be realized. Particularly when large-size electronic components and small-size electronic components are intermingled, high-speed mounting can hardly be achieved. In such a case, if it is desired to mount electronic components with high efficiency, a plurality of mounting apparatuses would be required depending on the types of electronic components, resulting in worse productivity and lower cost performance.

US-A-4 768 915 shows a component mounting apparatus comprising a component feed unit for intermittently feeding taped components, wherein a driving amount is variable according to the type of components.

### DISCLOSURE OF INVENTION

An object of the present invention is to provide electronic component mounting method and apparatus which are capable of achieving higher speed operation by varying the driving amount for intermittent feed of an electronic component according to the type of the electronic component, in view of the issues of the prior art as described above.

The mounting method of the present invention is defined in claim 1. The mounting apparatus of the present invention is defined in claim 3.

### BRIEF DESCRIPTION OF DRAWINGS

Fig. 1 is a perspective view of a general schematic construction of the electronic component mounting apparatus according to an embodiment of the present invention;
Fig. 2 is a perspective view showing the details of the component feed unit of the electronic component mounting apparatus according to the embodiment of the present invention;
Fig. 3A is a sectional plan view showing the construction of a feed drive changeover unit, which is an essential part of the electronic component mounting apparatus according to the embodiment of the present invention;
Fig. 3B is a front view showing the construction of the feed drive changeover unit, which is an essential part of the electronic component mounting apparatus according to the embodiment of the present invention;
Fig. 4 is a view showing a state of a large intermittent feed amount of the electronic component mounting apparatus according to the embodiment of the present invention;
Fig. 5 is a view showing a state of a small intermittent feed amount of the electronic component mounting apparatus according to the embodiment;
Fig. 6 is a view showing the position of a pivot pin in the same electronic component mounting apparatus;
Fig. 7A is a front view showing the construction of a feed drive changeover unit in another embodiment of the present invention;
Fig. 7B is a side view showing the construction of the feed drive changeover unit in another embodiment of the present invention;
Fig. 8A is a side view showing the construction of a feed lever driving unit in the same embodiment;
Fig. 8B is a front view showing the feed lever driving unit in the same embodiment;
Fig. 8C is a top view showing the feed lever driver driving unit in the same embodiment;
Fig. 9A is a top view showing the construction of an intermittent-feed amount changeover stopper unit in the same embodiment;
Fig. 9B is a side view showing the construction of the intermittent-feed amount changeover stopper unit in the same embodiment;
Fig. 10A is a front view of a component feed driving unit in an electronic component mounting apparatus according to the prior art; and
Fig. 10B is a side view of the component feed driving unit in the electronic component mounting apparatus according to the prior art.

### BEST MODE FOR CARRYING OUT THE INVENTION

In a preferred embodiment of the electronic component mounting method of the present invention, a plurality of lever driving units having different swing driving amounts for the feed lever are used and changed over to either one lever driving unit according to the intermittent feed amount.

In a preferred embodiment of the electronic component mounting apparatus of the present invention, the component feed unit comprises a feed lever for intermittently feeding the electronic components, and the component feed driving unit comprises a lever driving unit for driving the feed lever. Also, the lever driving unit has driving-amount variable means for arbitrarily varying the swing driving amount for the feed lever, or otherwise the electronic component mounting apparatus further comprises a plurality of lever driving units having different swing driving amounts for the feed lever, and selection means for selecting an arbitrary lever driving unit.

According to the electronic component mounting method and apparatus of the present invention, the relationship between the type of electronic components and the intermittent component-feed amount for the component feed unit is previously set and the driving amount for intermittently feeding the electronic components is varied according to the type of an electronic component recognized prior to its takeout from the component feed unit, so that the feed driving amount can be set to a minimum required one. Thus, high-speed mounting can be achieved.

Also, when the apparatus comprises a component feed unit for intermittently feeding taped electronic components, the type of an electronic component is recognized and the taping is driven into intermittent feed according to the intermittent feed amount corresponding to the type of the electronic component. Thus, the feed driving amount can automatically be set to a minimum required one so that high-speed mounting can be achieved.

Furthermore, the feed lever of the component feed unit is driven to swing according to the intermittent feed amount for taped electronic components, in which operation the swing driving amount for the feed lever is changed over according to the intermittent feed amount by using a lever driving unit that allows the swing driving amount for the feed lever to be arbitrarily changed over, or otherwise a plurality of lever driving units having different swing driving amounts for the feed lever are used and changed over to either one of them to be operated, according to the intermittent feed amount. Thus, the driving amount for the feed lever can be controlled to a minimum required one with simple construction and control, by which high-speed mounting can be realized.

### (First Embodiment)

Hereinbelow, an embodiment of the electronic component mounting apparatus according to the present invention is described with reference to the accompanying drawings.

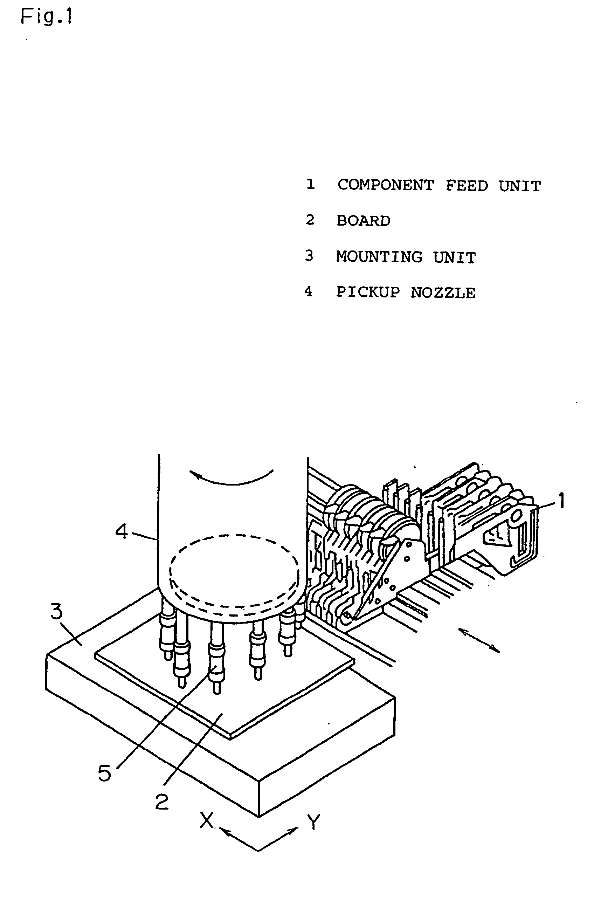

First, the electronic component mounting apparatus is outlined with reference to Fig. 1. The electronic component mounting apparatus, as shown in Fig. 1, comprises: a positioning table 3 for positioning a component feed unit 1 which accommodates electronic components therein and automatically feeds them, and a board 2 onto which electronic components are mounted, in two directions perpendicular to each other (in X- and Y-directions in the drawing); and a mounting unit 4 for picking up an electronic component automatically fed from the component feed unit 1 in a component pickup position by a pickup nozzle 5 and then transferring and mounting the electronic component to a specified position on the positioned board 2.

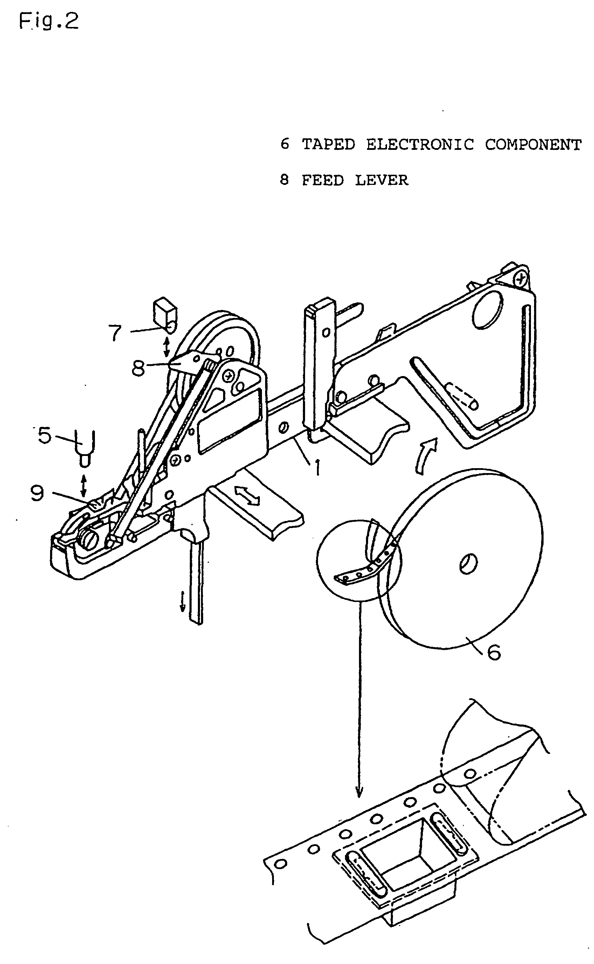

The component feed unit 1 is constructed as shown in Fig. 2. Taped electronic components 6 are fitted to the component feed unit 1. As a feed driving roller 7 moves up and down, a feed lever 8 swings up and down subordinately, so that the taped electronic components 6 are intermittently fed by a specified amount. As a result, an electronic component 6 is positioned to a specified position 9. Then, the pickup nozzle 5 moves up and down, by which the electronic component 6 is vacuum-picked up and afterwards mounted onto the board 2.

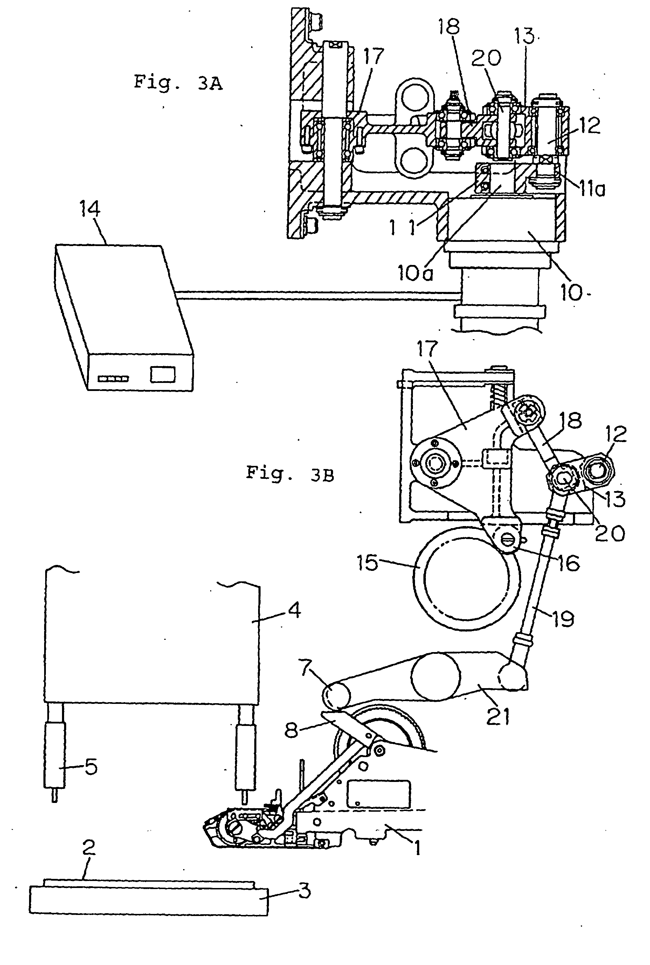

Figs. 3A, 3B show the general construction of the electronic component mounting apparatus according to the embodiment of the present invention, and further shows a detailed construction of the feed drive changeover unit for allowing the up-and-down moving amount of the feed driving roller 7 to be variable into an intermittent feed amount for the electronic component.

Referring to the figure, the component feed unit 1 is one as shown in Fig. 2, which swings the feed lever 8 up and down to thereby intermittently feed the electronic component by a specified amount.

A lever block 11 is fixed to an output shaft 10a of a changeover motor 10 for arbitrarily changing over the swing driving amount for the feed lever 8. One end of a pivot pin 12 is fixed to an end portion 11a of the lever block 11, and one end of a link block 13 is pivotally held to the other end of the pivot pin 12. A control unit 14 selects an intermittent feed amount for the taping according to the type of the electronic component recognized by a recognition means that recognizes the type of an electronic component, and controls the rotational position of the changeover motor 10 according to the recognized intermittent feed amount so that the position of the pivot pin 12 is moved via the lever block 11. Concretely, for example, a person recognizes the type of the electronic component and enters the type of the electronic component into the control unit 14 in which intermittent feed amounts corresponding to types of electronic components have previously been entered. Then, the control unit 14 selects the intermittent feed amount corresponding to the electronic component, and controls the rotational position of the changeover motor 10 according to the intermittent feed amount, thereby moving the position of the pivot pin 12 via the lever block 11.

This can be automatized by using a recognition means, such as a camera, that recognizes the type of an electronic component instead of a person who recognizes the type of an electronic component.

It is also possible that a person recognizes the type of an electronic component and enters an intermittent feed amount into the control unit.

A cam plate 15 is driven to rotate about a fixed axis in linkage with the mounting operation, and a roller 16 rotatably fitted to one end of a tilted-L shaped driving lever 17 whose intermediate portion is pivotally supported is engaged with the cam plate 15. One end of a first coupling link 18 is coupled to the other end of the driving lever 17, while the other end of the first coupling link 18, the other end of the link block 13 and one end of a second coupling link 19 are coupled together with a coupling pin 20. The other end of the second coupling link 19 is coupled to one end of a feed driving lever 21 whose intermediate portion is pivotally supported, and the feed driving roller 7 is fitted to the other end of the feed driving lever 21 and engaged with the feed lever 8 of the component feed unit 1.

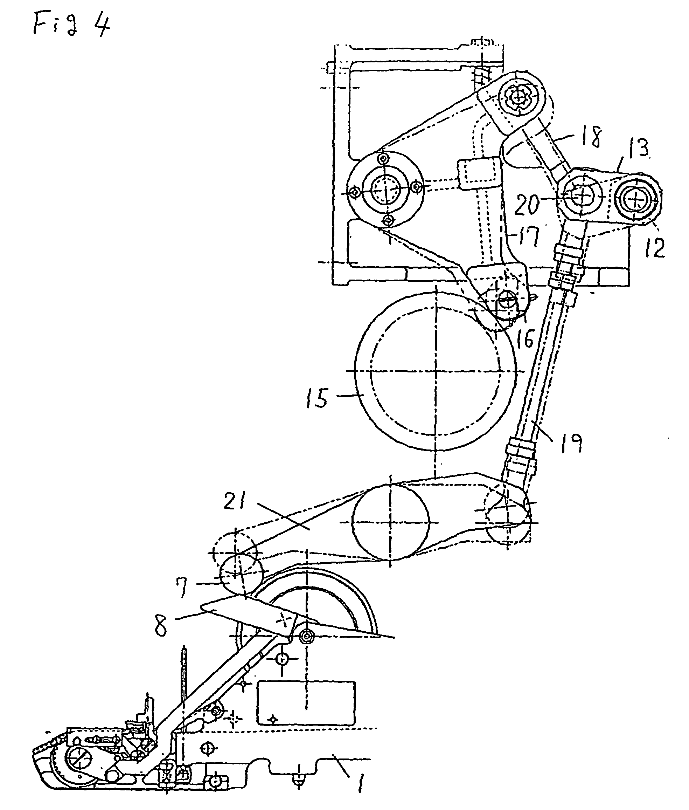

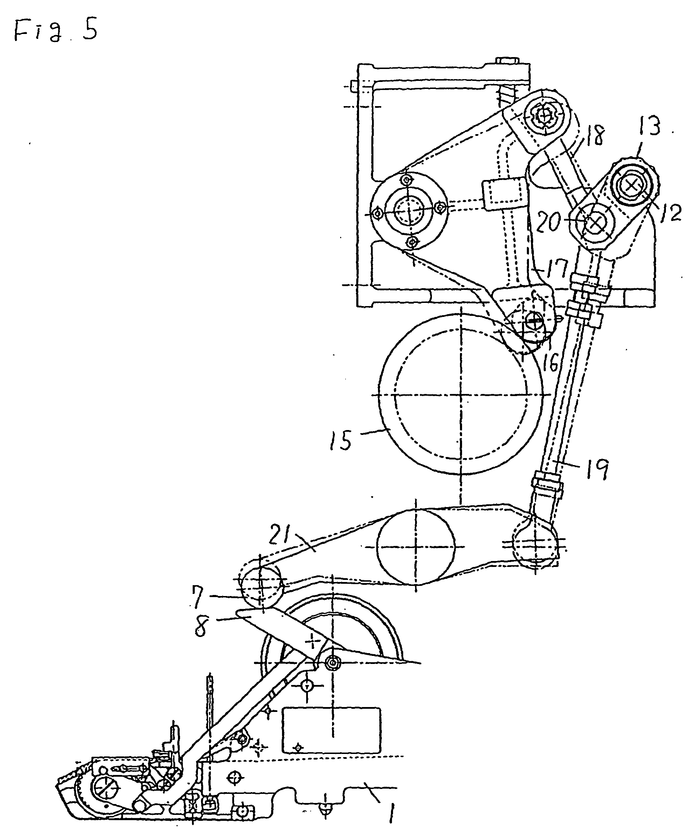

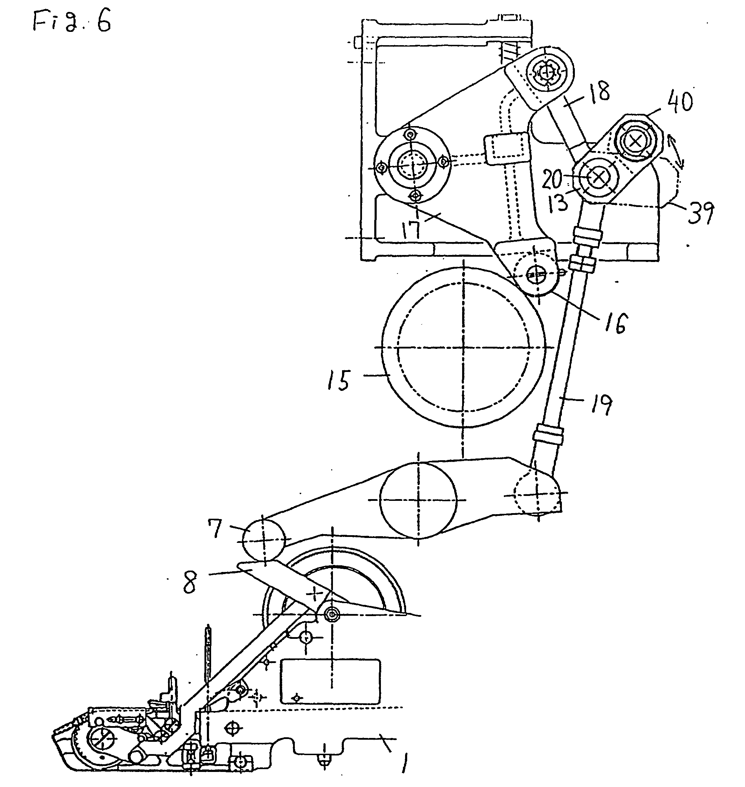

With this arrangement, the method for controlling the intermittent feed amount for an electronic component according to the type of the electronic component is next described. The following description is made on a case in which an electronic component that requires a large feed, such as ICs, and an electronic component that requires a small feed amount, such as chip components, are used, as an example. Figs. 4 and 5 are views for explaining operations of the electronic component mounting apparatus for large and small intermittent feed amounts of electronic components, respectively, where the positional relation therebetween at the maximum movement in the apparatus is represented by using solid line and two-dot chain line. Fig. 6 shows positions of the pivot pin that are changed over by the changeover motor.

The type of the electronic component is first recognized by the recognition means, and the intermittent feed amount of taping is selected according to the type of the recognized electronic component. After this, the following operation is carried out.

In the case of an electronic component that requires a large feed amount, when the changeover motor 10 is rotated, for example, from the state of Fig. 3 so that the pivot pin 12 is moved to a position shown in Fig. 4 (a position indicated at 39 in Fig. 6) via the lever block 11, the swinging direction of the other end of the link block 13 becomes generally aligned with the swinging direction of the other end of the driving lever 17. As a result, the swinging amount of the other end of the driving lever 17 is transferred to one end of the feed driving lever 21 via the first and second coupling links 18, 19 without being reduced so much.

As the driving lever 17 swings along with the rotation of the cam plate 15 in this way, the first and second coupling links 18, 19 move up and down while being regulated by the link block 13 swinging about the pivot pin 12, so that the feed driving lever 21 swings along with the movement of the coupling links 18, 19, causing the feed driving roller 7 to move up and down and the feed lever 8 of the component feed unit 1 to swing. As a result, the electronic components are intermittently fed. In this case, because the swinging amount of the driving lever 17 is transferred to the feed driving lever 21 without being reduced so much, the electronic components are intermittently fed in large steps.

In the case of an electronic component that requires a small feed amount, on the other hand, when the changeover motor 10 is rotated so that the pivot pin 12 is moved to a position shown in Fig. 5 (a position indicated at 40 in Fig. 6) via the lever block 11, the swinging direction of the other end of the link block 13 is aligned with a direction that crosses the swinging direction of the other end of the driving lever 17, so that the swinging amount of the other end of the driving lever 17 is transferred to one end of the feed driving lever 21 while being reduced to a large extent. As a result, even if the driving lever 17 swings in a similar manner along with the rotation of the cam plate 15, the electronic components are intermittently fed to a small extent.

As seen above, the position of the pivot pin 12 is changed by rotating the lever block 11 by means of the changeover motor 10, the up-and-down moving amount of the feed driving roller 7 is variably adjusted so that the swinging amount for the feed lever 8 of the component feed unit 1 can be changed over. Thus, the intermittent feed drive can be effected while an optimum swinging amount for the feed lever 8 is selected according to the type of the electronic component.

As described above, in this embodiment, by recognizing the type of an electronic component and driving the taping into intermittent feed according to an intermittent feed amount corresponding to the type of the electronic component, the feed driving amount can automatically be set to a minimum required amount, so that high-speed mounting can be achieved.

### (Second Embodiment)

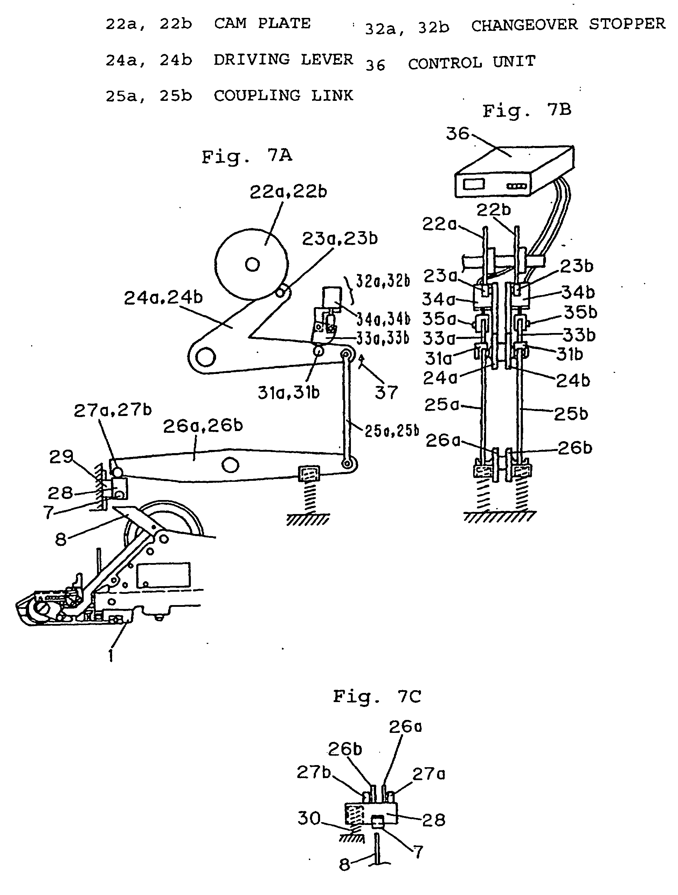

Next, another embodiment of the present invention is described with reference to Figs. 7A, 7B, 7C, 8A, 8B, 8C, 9A, 9B. The recognition of the type of an electronic component is similar to that described in the first embodiment.

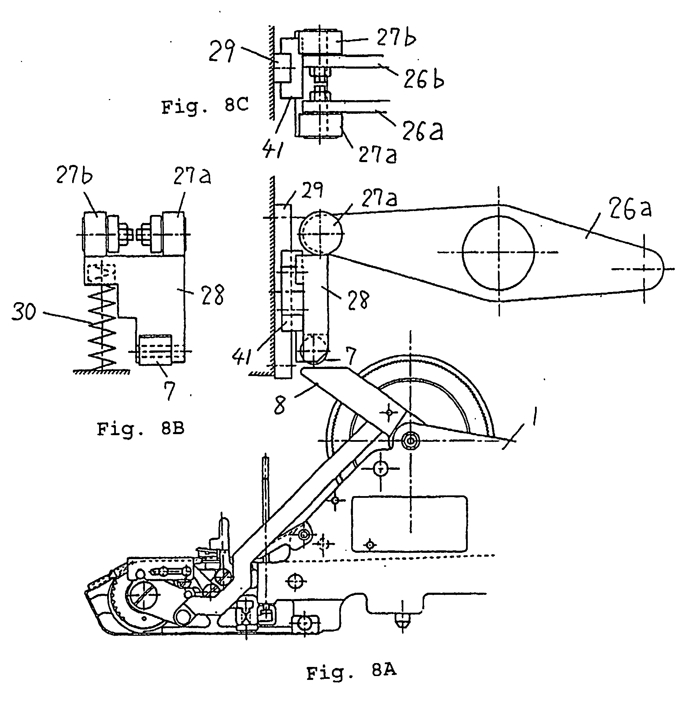

In this embodiment, there are juxtaposed two systems of lever driving unit comprising cam plates 22a, 22b, rollers 23a, 23b, driving levers 24a, 24b, coupling links 25a, 25b, feed driving levers 26a, 26b and rollers 27a, 27b fitted to the other ends of the feed driving levers 26a, 26b, all of which are coupled to one another sequentially. In this case, the driving levers 24a, 24b and the feed driving levers 26a, 26b are partly pivotally supported. Then, as shown in Figs. 8A, 8B, 8C, the rollers 27a, 27b are engaged with a block 28 having a pack 41 which is up-and-down movably supported by a guide 29. The block 28 is biased upward by a spring 30. A feed driving roller 7 is fitted to this block 28, and engaged with the feed lever 8 of the component feed unit 1.

Therefore, as the driving levers 24a, 24b swing along with the rotation of the cam plates 22a, 22b, the feed driving levers 26a, 26b swing via the coupling links 25a, 25b, so that the feed lever 8 of the component feed unit 1 is driven to swing by the feed driving roller 7 via the rollers 27a, 27b and the block 28. In this case, the component feed unit 1 is the same as that described in the first embodiment.

One cam plate 22a is formed into such a shape as to largely swing the feed lever 8, while the cam plate 22b is formed into such a shape as to small swing the feed lever 8.

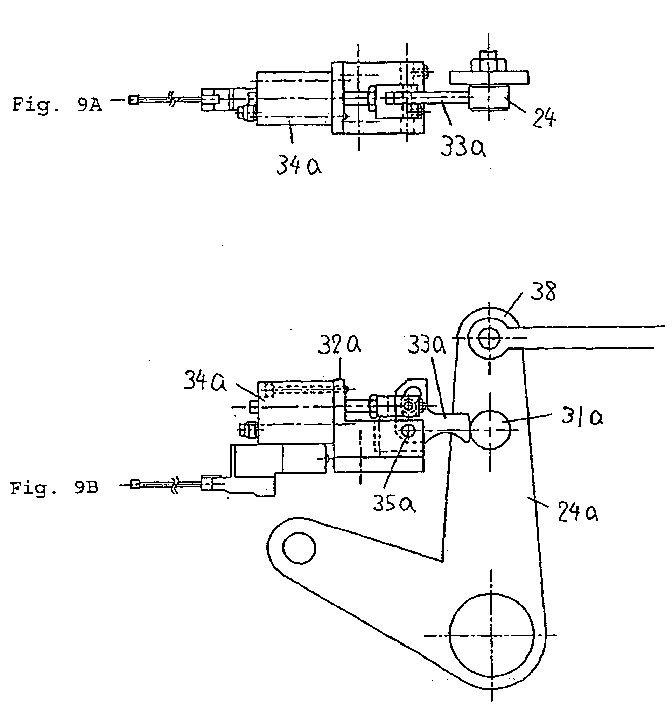

As shown in Figs. 9A, 9B, cam followers 31a, 31b are fitted to side faces of the driving levers 24a, 24b in proximity to the other ends thereof, and so arranged as to be engageable with stopper levers 33a, 33b of changeover stoppers 32a, 32b, respectively. The stopper levers 33a, 33b are driven by cylinders 34a, 34b to rotate about pins 35a, 35b, and so arranged as to be switchable between positions where they are engaged with the cam followers 31a, 31b so as to block the other end portion 38 of the driving lever 24a from moving upward, and positions where they are not engaged with the cam followers 31a, 31b so as to permit the other end portion 38 of the driving lever 24a to move upward. The cylinders 34a, 34b are selectively operable by a control unit 36. The control unit 36 recognizes the intermittent feed amount of the taping according to the type of the electronic component, and actuates either one of the cylinders 34a, 34b according to the recognized intermittent feed amount, makes the stopper lever 33a or 33b engaged with the cam follower 31a or 31b so that even if the cam plate 22a or 22b comes to a root (bottom) position (a position where the roller subordinate to the rotational center of the cam plate is the closest), the driving lever 24a or 24b will not swing in the direction of arrow 37.

With the above arrangement, by actuating the changeover stopper 32a or 32b according to the type of the electronic component with the control unit 36, the feed lever 8 of the component feed unit 1 is driven to swing by a swinging amount corresponding to the shape of either cam plate 22a or 22b, so that the intermittent feed can be driven while an optimum swinging amount for the feed lever 8 is selected according to the type of the electronic component.

In this way, by driving the taping into intermittent feed according to an intermittent feed amount corresponding to the type of the electronic component, the feed driving amount can automatically be set to a minimum required one, so that high-speed mounting can be achieved.

Although the present invention has been fully described in conjunction with preferred embodiments thereof with reference to the accompanying drawings, various changes and modifications will be apparent to those skilled in the art. Therefore, unless otherwise such changes and modifications depart from the scope of the present invention as defined by the appended claims, they should be construed as included therein.

### INDUSTRIAL APPLICABILITY

As apparent from the foregoing description, according to the electronic component mounting method of the present invention, the feed driving amount for intermittently feeding an electronic component is made variable according to the type of the electronic component, so that the feed driving amount can be set to a minimum required one, and that the electronic component can be intermittently fed in shorter time. Thus, high-speed mounting can be achieved.

Also, according to the electronic component mounting method and apparatus of the present invention, when the apparatus comprises a component feed unit for intermittently feeding taped electronic components, the type of an electronic component is recognized and the taping is driven into intermittent feed according to the intermittent feed amount corresponding to the type of the electronic component. Thus, the feed driving amount can automatically be set to a minimum required one so that high-speed mounting can be achieved.

Furthermore, the feed lever of the component feed unit is driven to swing according to the intermittent feed amount for taped electronic components, in which operation the swing driving amount for the feed lever is changed over according to the intermittent feed amount by using a lever driving unit that allows the swing driving amount for the feed lever to be arbitrarily changed over, or otherwise a plurality of lever driving units having different swing driving amounts for the feed lever are used and changed over to either one of them to be operated, according to the intermittent feed amount. Thus, the driving amount for the feed lever can be controlled to a minimum required one with simple construction and control, by which high-speed mounting can be realized.

### LIST OF REFERENCE NUMERALS OF DRAWINGS

- 1: component feed unit
- 2: board
- 4: mounting unit
- 5: pickup nozzle
- 6: taped electronic component
- 7: feed driving roller
- 8: feed lever
- 10: changeover motor
- 11: lever block
- 12: pivot pin
- 13: link block
- 14: control unit
- 15: cam plate
- 16: roller
- 17: driving lever
- 18: first coupling link
- 19: second coupling link
- 20: coupling pin
- 21: feed driving lever
- 22a, 22b: cam plate
- 24a, 24b: driving lever
- 25a, 25b: coupling link
- 26a, 26b: feed driving lever
- 32a, 32b: changeover stopper
- 36: control unit

## Claims

1. An electronic component mounting method for picking up an electronic component by a pickup nozzle from a component feed unit (1) that intermittently feeds taped electronic components according to a swing driving amount given to a feed lever (8), and mounting the picked-up electronic component onto a board, wherein the method comprises the following processes: a first process of previously setting relationships between types of the electronic components and intermittent component-feed amounts for the component feed unit, storing said relationships into a control unit (14) and recognizing a type of an electronic component prior to its takeout from the component feed unit; a second process of selecting an intermittent feed amount from said relationships stored in the control unit corresponding to the type of the electronic component recognized in the first process; and a third process of arbitrarily varying the swing driving amount for the feed lever of the component feed unit by a driving-amount variable means (10, 12, 13, 20 ; 32a, 32b-34a, 34b), the feed lever being drivable into swing, according to the intermittent feed amount selected in the second process under the control of the control unit (14).

2. The electronic component mounting method according to Claim 1, **characterized in that** a plurality of lever driving units having different swing driving amounts for the feed lever are used and changed over to either one lever driving unit according to the intermittent feed amount.

3. An electronic component mounting apparatus, comprising: a component feed unit (1) for accommodating electronic components therein so as to allow the electronic components to be intermittently fed; recognition means for recognizing a type of an electronic component prior to its takeout from the component feed unit; a mounting unit (3) for picking up an electronic component from the component feed unit (1) and mounting the electronic component to a specified position on a board (2); a component feed driving unit (7, 15-19, 21; 7, 22a, 22b-27a, 27b, 28, 29, 31 a, 31b) for driving the component feed unit (1) to intermittently feed the electronic components; and a control unit (14) for storing relationships between types of the electronic components and intermittent component-feed amounts for the component feed unit (1) wherein these relationships have been set previously, and for selecting an intermittent feed amount of the component feed unit (1) according to the type of the electronic component recognized by the recognition means, and controlling the component feed driving unit (7, 15-19, 21; 7, 22a, 22b-27a, 28, 29, 31a, 31 b) by a driving-amount variable means (10, 12, 13, 20; 32a, 32b-34a, 34b) in order to intermittently feed the electronic component by the selected specified amount.

4. The electronic component mounting apparatus according to claim 3, **characterized in that** the component feed unit (1) comprises a feed lever (8) for intermittently feeding the electronic components, and the component feed driving unit comprises a lever driving unit (7, 15-19, 21) for driving the feed lever (8).

5. The electronic component mounting apparatus according to claim 4 **characterized in that** the lever driving unit (7, 15-19, 21) has driving-amount variable means (10, 12, 13, 20) for arbitrarily varying the swing driving amount for the feed lever (8).

6. The electronic component mounting apparatus according to claim 4, **characterized by** further comprising a plurality of lever driving units (7, 22a, 22b-27a, 27b, 28, 29, 31 a, 31b) having different swing driving amounts for the feed lever (8) and selection means (32a, 32b-34a, 34b) for selecting an arbitrary lever driving unit (7, 22a, 22b-27a, 27b, 28, 29, 31 a, 31b).

## Patentansprüche

1. Verfahren zum Bestücken mit elektronischen Bauelementen, bei dem ein elektronisches Bauelement von einer Ansaugdüse aus einer Bauelement-Zuführeinheit (1) aufgenommen wird, die an einem Band befestigte elektronische Bauelemente entsprechend der auf einen Zustellhebel (8) übertragenen Schwenkantriebskraft intermittierend zuführt, und das aufgenommene elektronische Bauelement auf einer Leiterplatte montiert wird, wobei das Verfahren die folgenden Schritte umfasst:
einen ersten Schritt, bei dem die Beziehungen zwischen verschiedenartigen elektronischen Bauelementen und dem jeweiligen intermittierenden Bauelement-Zustellbetrag voreingestellt sowie diese Beziehungen in einer Steuereinheit (14) gespeichert werden und bei dem die Art des elektronischen Bauelements erkannt wird, bevor es aus der Bauelement-Zuführeinheit aufgenommen wird,
einen zweiten Schritt, bei dem der Betrag der intermittierenden Zustellung, der dem jeweiligen im ersten Schritt erkannten elektronischen Bauelement zugeordnet ist, aus den in der Steuereinheit gespeicherten Beziehungen ausgewählt wird, und
einen dritten Schritt, bei dem die Schwenkantriebskraft des Zustellhebels der Bauelement-Zuführeinheit von einem Zustellbetragänderungsmittel (10, 12, 13, 20; 32a, 32b-34a, 34b) willkürlich geändert wird, wobei der Zustellhebel von der Steuereinheit (14) gesteuert entsprechend dem im zweiten Schritt ausgewählten Betrag der intermittierenden Zustellung geschwenkt werden kann.

2. Verfahren zum Bestücken mit elektronischen Bauelementen nach Anspruch 1, **dadurch gekennzeichnet, dass** mehrere Hebelantriebseinheiten mit unterschiedlichen Schwenkantriebsbeträgen für den Zustellhebel verwendet werden und je nach dem Betrag der intermittierenden Zustellung auf die entsprechende Hebelantriebseinheit umgeschaltet wird.

3. Vorrichtung für die Bestückung mit elektronischen Bauelementen, enthaltend:
eine Bauelement-Zuführeinheit (1), in der elektronische Bauelemente aufgenommen sind, damit sie intermittierend zugestellt werden können; Erkennungsmittel zum Erkennen des jeweiligen elektronischen Bauelements, bevor es aus der Bauelement-Zuführeinheit herausgenommen wird; eine Bestückungseinheit (3) zum Aufnehmen eines elektronischen Bauelements aus der Bauelement-Zuführeinheit (1) und Befestigen des elektronischen Bauelements an einer bestimmten Stelle auf einer Leiterplatte (2); eine Antriebseinheit (7, 15-19, 21; 7, 22a, 22b-27a, 27b, 28, 29, 31a, 31b) zur Bauelementzustellung, mit der die Bauelement-Zuführeinheit (1) angetrieben wird, um die elektronischen Bauelemente intermittierend zuzustellen; und eine Steuereinheit (14) zum Speichern der Beziehungen zwischen den verschiedenartigen elektronischen Bauelementen und den Beträgen der intermittierenden Zustellung für die Bauelement-Zuführeinheit (1), wobei diese Beziehungen voreingestellt worden sind, und zum Auswählen des Betrags der intermittierenden Zustellung der Bauelement-Zuführeinheit (1) entsprechend dem jeweiligen vom Erkennungsmittel erkannten elektronischen Bauelement, sowie zum Steuern der Bauelementzustell-Antriebseinheit (7, 15-19, 21; 7, 22a, 22b-27a, 28, 29, 31a, 31b) durch ein Zustellbetragveränderungsmittel (10, 12, 13, 20; 32a, 32b-34a, 34b), um das elektronische Bauelement um den jeweils ausgewählten Betrag intermittierend zuzustellen.

4. Vorrichtung zur Bestückung mit elektronischen Bauelementen nach Anspruch 3, **dadurch gekennzeichnet, dass** die Bauelement-Zuführeinheit (1) einen Zustellhebel (8) zum intermittierenden Zustellen der elektronischen Bauelemente hat und dass die Bauelementzustell-Antriebseinheit eine Hebelantriebseinheit (7, 15-19, 21) zum Antreiben des Zustellhebels (8) hat.

5. Vorrichtung zur Bestückung mit elektronischen Bauelementen nach Anspruch 4, **dadurch gekennzeichnet, dass** die Hebelantriebseinheit (7, 15-19, 21) Antriebsbetragänderungsmittel (10, 12, 13, 20) zum willkürlichen Ändern des Schwenkbetrags für den Zustellhebel (8) hat.

6. Vorrichtung zur Bestückung mit elektronischen Bauelementen nach Anspruch 4, **dadurch gekennzeichnet, dass** sie zusätzlich mehrere Hebelantriebseinheiten (7, 22a, 22b-27a, 27b, 28, 29, 31a, 31b) mit unterschiedlichen Schwenkantriebsbeträgen für den Zustellhebel (8) und Auswählmittel (32a, 32b-34a, 34b) zum Auswählen einer der Hebelantriebseinheiten (7, 22a, 22b-27a, 27b, 28, 29, 31a, 31b) hat.

## Revendications

1. Procédé de montage d'un composant électronique pour saisir un composant électronique au moyen d'une buse de saisie à partir d'une unité d'alimentation en composants (1) qui alimente de façon intermittente des composants électroniques sur bande selon une quantité entraînée par un système à balancier vers un levier d'alimentation (8), et qui monte le composant électronique saisi sur une carte, dans lequel le procédé comprend les processus suivants : un premier processus de réglage préalable des relations entre les types de composants électroniques et les quantités d'alimentation intermittentes de composants pour l'unité d'alimentation du composant, le stockage desdites relations dans une unité de commande (14), et la reconnaissance d'un type d'un composant électronique avant sa prise à partir de l'unité d'alimentation en composants ; un deuxième processus de sélection d'uné quantité d'alimentation intermittente depuis lesdites relations stockées dans l'unité de commande correspondant au type de composant électronique reconnu dans le premier processus ; et un troisième processus de variation arbitraire de la quantité entraînée par le système à balancier vers le levier d'alimentation de l'unité d'alimentation en composant par un moyen variable d'entraînement des quantités (10, 12, 13, 20 ; 32a, 32b à 34a, 34b), le levier d'alimentation étant entraînable dans le balancier, selon la quantité d'alimentation intermittente sélectionnée dans le deuxième processus sous le contrôle de l'unité de commande (14).

2. Procédé de montage d'un composant électronique selon la. revendication 1, **caractérisé en ce que** l'on utilise et que l'on change l'une après l'autre les unités d'entraînement de levier d'une pluralité d'unités d'entraînement de leviers de commandes ayant différentes quantités entraînées par un système à balancier vers le levier d'alimentation selon la quantité d'alimentation intermittente.

3. Dispositif de montage de composants électroniques, comprenant : une unité d'alimentation en composants (1) pour y contenir des composants électroniques de telle façon de permettre aux composants électroniques d'être alimentés de façon intermittente ; des moyens de reconnaissance pour reconnaître un type de composant électronique avant sa prise à partir de l'unité d'alimentation en composants ; une unité de montage (3) pour saisir un composant électronique à partir de l'unité d'alimentation en composant (1) et le montage du composant électronique à un emplacement spécifié sur une carte (2) ; une unité d'entraînement d'alimentation (7, 15 à 19, 21 ; 7, 22a, 22b à 27a, 27b, 28, 29, 31a, 31b) pour entraîner l'unité d'alimentation du composant (1) pour alimenter de façon intermittente les composants électroniques ; et une unité de commande (14) pour stocker les relations entre les types de composants électroniques et les quantités d'alimentation intermittente en composants pour l'unité d'alimentation du composant (1) dans lequel on a préalablement réglé ces relations, et pour sélectionner une quantité d'alimentation intermittente de l'unité d'alimentation du composant (1) selon le type de composants électroniques reconnus par le moyen de reconnaissance, et la commande de l'unité d'entraînement d'alimentation du composant (7, 15 à 19, 21 ; 7, 22a, 22b à 27a, 28, 29, 31a, 31b) par un moyen variable d'entraînement de quantité (10, 12, 13, 20 ; 32a, 32b à 34a, 34b) de façon à alimenter de façon intermittente le composant électronique au moyen de la quantité spécifiée sélectionnée.

4. Dispositif de montage de composants électroniques selon la revendication 3, **caractérisé en ce que** l'unité d'alimentation de composant (1) comprend un levier d'alimentation (8) pour alimenter de façon intermittente en composants électroniques, et l'unité d'entraînement d'alimentation en composants comprend une unité de leviers d'entraînement (7, 15 à 19, 21) pour entraîner le levier d'alimentation (8).

5. Dispositif de montage de composants électroniques selon la revendication 4, **caractérisé en ce que** l'unité de leviers d'entraînement (7, 15 à 19, 21) a un moyen variable d'entraînement de quantités (1à, 12, 13, 20) pour varier de façon arbitraire la quantité entraînée par le système à balancier vers le levier d'alimentation (8).

6. Dispositif de montage de composants électroniques selon la revendication 4, **caractérisé en ce qu'**il comprend de plus une pluralité d'unités d'entraînement de leviers (7, 22a, 22b à 27a, 27b, 28, 29, 31a, 31b) ayant différentes quantités entraînées par le système à balancier vers le levier d'alimentation (8) et un moyen de sélection (32a, 32b à 34a, 34b) pour sélectionner une unité d'entraînement de levier arbitraire (7, 22a, 22b à 27a, 27b, 28, 29, 31a, 31b).
